# EUROPEAN PATENT SPECIFICATION

(11) **EP 2 801 114 B1**
(45) Date of publication and mention of the grant of the patent: **03.06.2020**
(21) Application number: 12864072.9
(22) Date of filing: 13.12.2012
(51) Int. Cl.: H01L 29/872, H01L 29/78, H01L 29/739, H01L 21/336, H01L 21/329, H01L 29/40, H01L 29/06

(54) **SEMICONDUCTOR DEVICE WITH IMPROVED TERMINATION STRUCTURE FOR HIGH VOLTAGE APPLICATIONS AND METHOD OF MANUFACTURING THE SAME**
HALBLEITERVORRICHTUNG MIT VERBESSERTER ANSCHLUSSSTRUKTUR FÜR HOCHSPANNUNGSANWENDUNGEN UND VERFAHREN ZU DEREN HERSTELLUNG
DISPOSITIF SEMI-CONDUCTEUR DOTÉ D'UNE STRUCTURE DE RACCORDEMENT AMÉLIORÉE POUR DES APPLICATIONS HAUTE TENSION ET SON PROCÉDÉ DE FABRIACATION

(30) Priority: 04.01.2012 US 201213343435
(43) Date of publication of application: 12.11.2014
(73) Proprietor: Vishay General Semiconductor LLC, Hauppauge, NY 11788 (US)
(72) Inventor: LIN, Yih-yin, Taipei 10664 (TW); LIN, Pai-li, Fengyuan City Taichung County 420 (TW); HSU, Chih-wei, Taipei 105 (TW)
(74) Representative: Engel, Christoph Klaus
(86) International application number: PCT/US2012/069440
(87) International publication number: WO 2013/103491

(56) References cited:
- EP-A2- 1 191 603
- US-A1- 2002 100 935
- US-A1- 2005 127 465
- US-A1- 2006 214 242
- US-A1- 2007 052 014
- US-A1- 2011 227 152
- US-A1- 2011 227 152
- US-B2- 6 621 107
- US-B2- 8 017 494

## Description

### Field of the Invention

The present invention relates generally to a semiconductor device, and more particularly to a termination structure for a trench MOS device. The present invention further relates to a Schottky diode and to a method of forming a semiconductor device.

### Background

US 8,017,494 B2 shows in Fig. 1 a semiconductor device that includes an active region 10 and a termination region 12. Active region 10 includes at least one gate trench 14 which extends through base region 16 to drift region 18. Gate oxide 20 is formed on the sidewalls of gate trench 14, a thick oxide 22 is formed at the bottom of gate trench 14, and a gate electrode 24 is formed inside trench 14. The termination region 12 includes four spaced termination trenches 36 that surround the active region 10. Each termination trench 36 includes a silicon dioxide body 38 that lines the bottom surface and sidewalls thereof. Conductive polysilicon spacers 59 are located along the sidewalls of each termination trench 36 and another silicon dioxide body 40 overlays the polysilicon spacers 59 to fill the remainder of the termination trenches.

Conventionally, a Schottky diode includes a heavily-doped semiconductor substrate, typically made of single-crystal silicon. A second layer covers the substrate. The second layer, called the drift region, is less heavily-doped with impurities having carriers of the same conducting type as the substrate. A metal layer or a metal silicide layer forms a Schottky contact with the lightly-doped drift region and forms the diode anode.

Two opposing constraints arise when forming a unipolar component such as a Schottky diode. In particular, the components should exhibit the lowest possible on-state resistance (Ron) while having a high breakdown voltage. Minimizing the on-state resistance imposes minimizing the thickness of the less doped layer and maximizing the doping of this layer. Conversely, to obtain a high reverse breakdown voltage, the doping of the less doped layer must be minimized and its thickness must be maximized, while avoiding the creation of areas in which the equipotential surfaces are strongly bent.

Various solutions have been provided to reconcile these opposite constraints, which has led to the development of trench MOS-capacitance Schottky diode structures, which are referred to as Trench MOS Barrier Schottky (TMBS) diodes. In an example of such devices, trench regions are formed in the upper portion of a thick drift layer that is less heavily doped with impurities of the same conductivity type than the underlying substrate. The trench regions are filled with a MOS structure. An anode metal layer is evaporated to cover the entire surface and forms a Schottky contact with the underlying drift region.

When reverse biased, the insulated conductive areas cause a lateral depletion of charge into the drift region, which modifies the distribution of the equipotential surfaces in this layer. This enables increasing the drift region doping, and thus reducing the on-state resistance with no adverse effect on the reverse breakdown voltage.

A key issue for achieving a high voltage Schottky rectifier is the design of its termination region. As with any voltage design, the termination region is prone to higher electric fields due to the absence of self multi-cell protection and the curvature effect. As a result, the breakdown voltage is typically dramatically reduced from its ideal value. To avoid this reduction, the termination region should be designed to reduce the crowding of the electric field at the edge of the device (near the active region). Conventional approaches to reduce electric field crowding include termination structures with local oxidation of silicon (LOCOS) regions, field plates, guard rings, trenches and various combinations thereof. For instance, in some devices multiple guard ring trenches have been employed. One example of a Schottky diode that includes a conventional termination region is shown in U.S. Patent No. 6,396,090 and in its family member EP 1 191 603 A2.

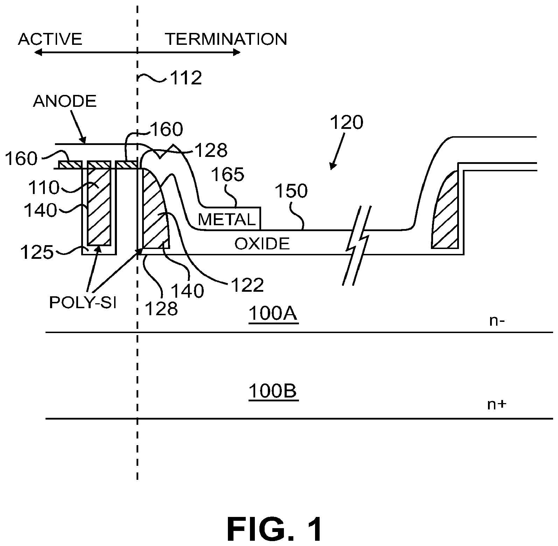

FIG. 1 shows a simplified, cross-sectional view of the active and termination regions of a TMBS Schottky diode of the type shown in U.S. Pat. Appl. Pub. No. US 2011/0227151 A1. The active region includes a semiconductor substrate 100B that is heavily doped with a dopant of a first conductivity type (e.g., n+ type). A first layer 100A is formed on the substrate 100B and is more lightly doped with a dopant of the first conductivity type (e.g., n- type). Trenches 110 (only one of which is shown) are formed in the first layer 100A. The trenches 110 are lined with an insulating layer 125 and filled with a conductive material 140 such as doped polysilicon. A metal layer 165 is formed over the exposed surfaces of the conductive material 140 and the first layer 100A, thereby forming a Schottky contact 160 at the interface between the metal layer 165 and the first layer 100A. A cathode electrode (not shown) is located on the backside of the semiconductor substrate 100B.

The termination region of the TMBS Schottky diode shown in FIG. 1 includes a termination trench 120 that extends from the boundary 112 with the active region toward an edge of the semiconductor substrate 100B. A MOS gate 122 is formed on a sidewall of the termination region adjacent to the boundary 112 with the active region. The MOS gate 122 includes an insulating material 128 and a conductive material 122. The insulating material 128 lines the sidewall against which the MOS gate 122 is located and the portion of the first layer 100A adjacent to the sidewall. A conductive material 122 covers the insulating material 128. A termination oxide layer 150 is formed in the termination trench 120 and extends from the MOS gate 122 toward the edge of the device. The metal layer 165 located in the active region extends into the termination region and covers the MOS gate 122 and a portion of the termination oxide layer 150 to thereby define a field plate.

Unfortunately, for high voltage applications these conventional designs for the termination region have had only limited success because the electric field distribution at the surface of the termination region is still far from ideal. Because of the limited length of the drift region, the electric field rises rapidly at the end of active region due to the asymmetry. As a result the breakdown of the device is dominated by edge breakdown.

The conventional device shown in FIG. 1 has been driven to 200V, but at this point its performance is already degrading because of the early breakdown at the surface of the termination region. Consequently the reliability of this design largely depends on the end position of the field plate 165 in the termination regions. Normally, the metal wet etching process used in the formation of the field plate 165 can only be controlled to a precision within about ±6 µm, and this variability can have a significant impact on the device's reverse blocking voltage. For instance, a short field plate will exaggerate the electric field near the corner of the last active cell, resulting in premature breakdown. On the other hand, a longer field plate that extends to a point near the remote spacer can degrade the breakdown voltage as well, while also causing mechanical stress at its elongated metal end.

**Table 1: Breakdown voltage vs. metal field plate length of conventional TMBS termination**

| | | | | | | | |
|---|---|---|---|---|---|---|---|
| Extended Metal Length Variation (µm) | -4 | -2 | 0 | +2 | +4 | +6 | +8 |
| Breakdown Voltage, V_{br}(V) | 235 | 277 | 278 | 276 | 271 | 269 | 261 |
| Breakdown Fluctuation (%) | -15.5 | -0.72 | - | -0.72 | -2.52 | -3.24 | -6.14 |

Table 1 shows the variation in breakdown voltage as a function of the length of the metal field plate. The data were obtained from a simulation of a drift layer designed for high breakdown voltage TMBS devices with a 20 µm termination trench. It should be noted that the breakdown voltage of the unit cell with the same parameters of the drift region is 375V, and, as the Table shows, the highest breakdown voltage achievable with the conventional termination design is 74% of the ideal value.

### Summary of the Invention

In accordance with the present invention, it is provided a semiconductor device comprising a termination structure according to claim 1.

In accordance with another aspect of the invention, the semiconductor device is a Schottky diode which includes a semiconductor substrate having a plurality of trench MOS devices spaced from each other formed in an active region of the semiconductor substrate. The second conductive layer is formed atop the active region to define one or more Schottky barriers with one or more portions of the substrate located between adjacent ones of the trench MOS devices. The second conductive layer extends as a field plate over an exposed portion of the MOS gate and a portion of the termination structure oxide layer disposed on the termination trench and the guard ring trench.

In accordance with another aspect of the invention a method of forming a semiconductor device according to claim 11 is provided.

### Brief Description of the Drawings

FIG. 1 is a simplified, partial view of a conventional TMBS Schottky diode or rectifier.
FIG. 2 shows a cross-sectional view of the active and termination regions of a TMBS Schottky diode constructed in accordance with the present invention.
FIG. 3 shows a comparison of the breakdown voltage (BV) as a function of the metal lengths of the device shown in FIG. 2 and a conventional TMBS.
FIG. 4 shows both the electric field along the y-axis of the embodiment shown in FIG. 2 under a 250V reverse bias and the electric field of a conventional TMBS.
FIGs. 5-8 illustrate one example of the process steps that may be employed to fabricate the device of FIG. 2.
FIG. 9 illustrates an alternative embodiment of the termination structure with segmented metal field plates.

### Detailed Description

As detailed below, a termination structure is provided which reduces the aforementioned problems. The structure includes a termination trench as well as one or more additional trench cells that extend beyond the termination trench and act as guard rings. An extended metal field plate covers both the termination trench and the one or more guard rings. Such a termination structure can extend the boundary of the electric field profiles while additional guard rings can further reduce the impact on the electric field distribution which arises from variations in the length of the field plate. Simulation results will be presented showing the influence of up to 4 guard rings on the breakdown voltage.

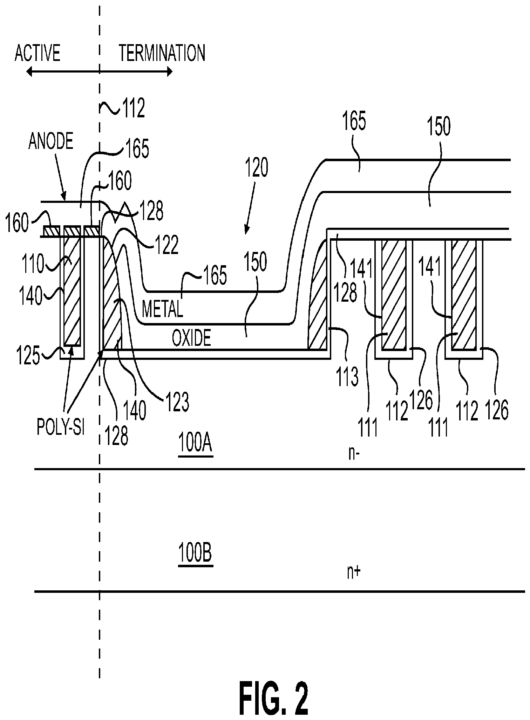

FIG. 2 shows a cross-sectional view of the active and termination regions of a TMBS Schottky diode constructed in accordance with one example of the present invention. The active region includes a semiconductor substrate 110B that is heavily doped with a dopant of a first conductivity type (e.g., n+ type). A first layer 100A is formed on the substrate 100B and is more lightly doped with a dopant of the first conductivity type (e.g., n- type). Trenches 110 (only one of which is shown) are formed in the first layer 100A. The trenches 110 are lined with an insulating layer 125 and filled with a conductive material 140 such as doped polysilicon. A metal layer 165 is formed over the exposed surfaces of the conductive material 140 and the first layer 100A, thereby forming a Schottky contact at the interface between the metal layer 165 and the first layer 100A. A cathode electrode (not shown) is located on the backside of the semiconductor substrate 100B.

The termination region of the TMBS Schottky diode shown in FIG. 2 includes a termination trench 120 that begins at the boundary 112 with the active region and extends toward an edge of the semiconductor substrate 100B. Beyond the termination trench 120, closer to the edge of the drift region 100A is one or more trench cells 111 that are part of the termination region. In this example two such trench cells 111 are shown.

A MOS gate 122 is formed on a sidewall of the termination trench 120 adjacent to the boundary 112 with the active region. The MOS gate 122 includes an insulating material 128 and a conductive material 123. The insulating material 128 lines the sidewall against which the MOS gate 122 is located and the portion of the first layer 100A adjacent to the sidewall. The conductive material 123 covers the insulating material 128.

The trench cells 111 are lined with an insulating layer 126 and filled with a conductive material 141 such as doped polysilicon. A termination oxide layer 150 is formed in the termination trench 120 and extends from the MOS gate 122 toward the edge of the device and over the remote sidewall 113 of the termination trench 120 and covering guard ring trenches 111. The metal layer 165 located in the active region extends into the termination region and covers the termination trench 120 as well as the guard ring trenches 111. The metal layer 165, which serves as a field plate, may extend beyond the guard ring trenches 111 toward the edge of the device.

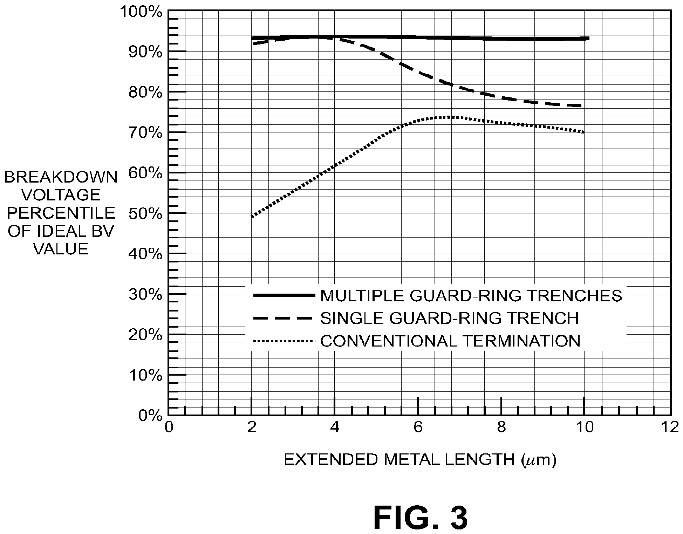

FIG. 3 illustrates the breakdown voltage fluctuation under the influence of various metal field plate lengths. The illustrated breakdown voltage in the figure is shown as a percentile of the ideal breakdown voltage of a TMBS active cell without termination. The three curves belong to three devices: two for the embodiments as in FIG. 2 but with one or four guard ring trenches. The other one has the conventional TMBS termination as in FIG. 1. As can be seen, a combined termination trench with multiple guard ring trenches cannot only enhance the breakdown voltage but also reduce the sensitivity of the BV to metal lengths. The maximum breakdown voltage in this figure can reach 94% of its ideal value while the conventional termination is only 75% at the highest value.

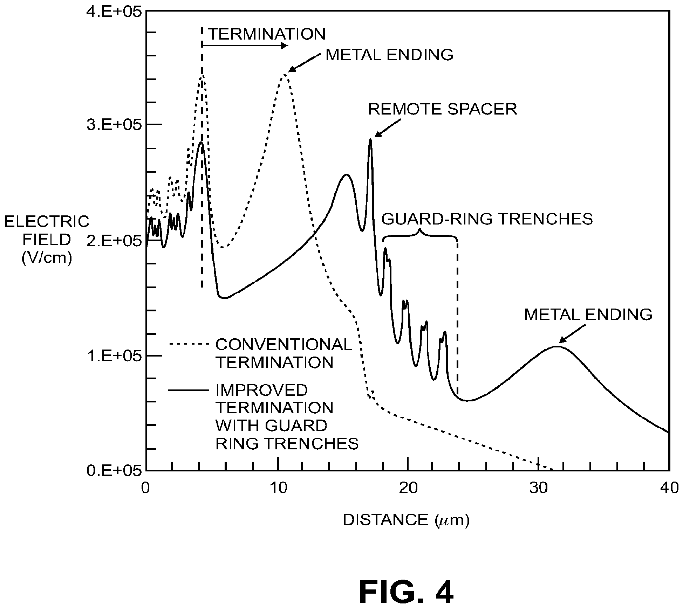

FIG. 4 compares the electric fields along the y-axis under a 250V reverse bias for the termination structure shown in FIG. 2 and FIG. 1. In the conventional TMBS, the peak field occurs at the anode metal ending. As can be observed, the addition of guard ring trenches extends the field distribution and thus increase the reverse capability.

One important advantage of the structure shown in FIG. 2 is that its fabrication does not require any additional processing steps beyond those used to fabricate the conventional TMBS device shown in FIG. 1. Compared to traditional edge termination technology, no additional control of the diffusion processes or complex multi-field plate settings are required. For instance, the trenches for the guard rings can be formed simultaneously with trenches in the active region. In addition, the insulating layers 125 and 126 can be formed simultaneously with one another and the conductive material 140 and 141 can be deposited simultaneously with one another.

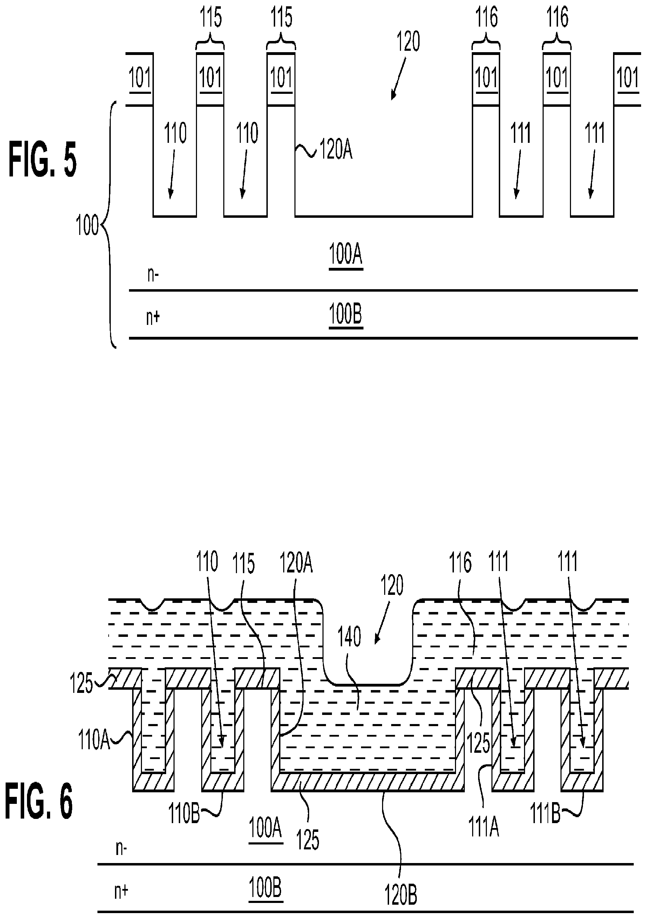

One example of a method that may be employed to form the TMBS Schottky diode of FIG. 2 will be described with reference to FIGs. 5- 8. In this example the Schottky diode and its termination structure are formed simultaneously, though this need not always be the case.

FIG. 5 is a cross-sectional view of a semiconductor substrate 100 that includes a first layer 100A having a dopant of a first conductivity type (e.g., n- type) and a base substrate 100B which is more heavily doped with a dopant of the first conductivity type (e.g., n+ type). An oxide layer 101 is formed on the first substrate 100 A by chemical vapor deposition (CVD), for example, to a thickness of about 200 - 1,000 nm (2000-10,000 angstroms). Next, a photoresist (not shown) is coated on the oxide layer 101 to define a plurality of active region trenches 110 in the active region, a termination trench 120 in the termination region and guard ring trenches 111 after the termination trench. In this example two guard ring trenches are shown, though one of ordinary skill will recognize that the same process may be used to form a device with any number of guard ring trenches. The trenches 1 10 are spaced apart from one another by mesas 115 and the guard ring trenches 111 are separated from one another and the termination trench 120 by mesas 116. In one example each of the active region trenches 110 is about 0.2-2.0 microns in width The termination trench 120 forms the boundary from the edge of the active region to an edge of the semiconductor substrate 100 (or a die) and defines the termination region. In one example the termination trench 120 has a width of 12 µm and the guard rings trenches have a width of 0.5 µm.

Referring to FIG. 6 after removal of the oxide layer 101, a high temperature oxidation process is performed to form gate oxide layer 125. The gate oxide layer 125, which in some examples has a thickness between about 15 nm (150 angstroms) and 300 nm (3000 angstroms), is formed on the sidewalls 110A, 120A and bottoms HOB, 120B of the first and second trenches 110, 120 and the surface of mesa 115. The gate oxide layer 125 is also formed on the sidewalls 111A and 111B of guard ring trenches 111. The gate oxide layer 125 lining all the various trenches may be formed simultaneously in a single process. Instead of an oxidation process, the gate oxide layer 125 may be formed by high temperature deposition to form a HTO (high temperature oxide deposition) layer.

Next, also referring to FIG. 6 a first conductive layer 140 is formed by CVD on the gate oxide 125 and fills the active trenches 110, the termination trench 120 and the guard ring trenches 111. The first conductive layer 140 has a thickness such that it extends over mesas 115 and 116. The first conductive layer 140 may be any suitable material such as a metal, doped-polysilicon or doped-amorphous silicon. The first conductive layer 140 may have a thickness of about 0.5 to 3.0 microns. In order to prevent voids from forming in the inner portion of the trenches 1 10, the first conductive layer 140 may be polysilicon formed by an LPCVD (low pressure CVD) process, which has good step coverage. However, in some cases amorphous silicon may be better able to eliminate voids than polysilicon. To make the amorphous silicon conductive a recrystallization process may be employed.

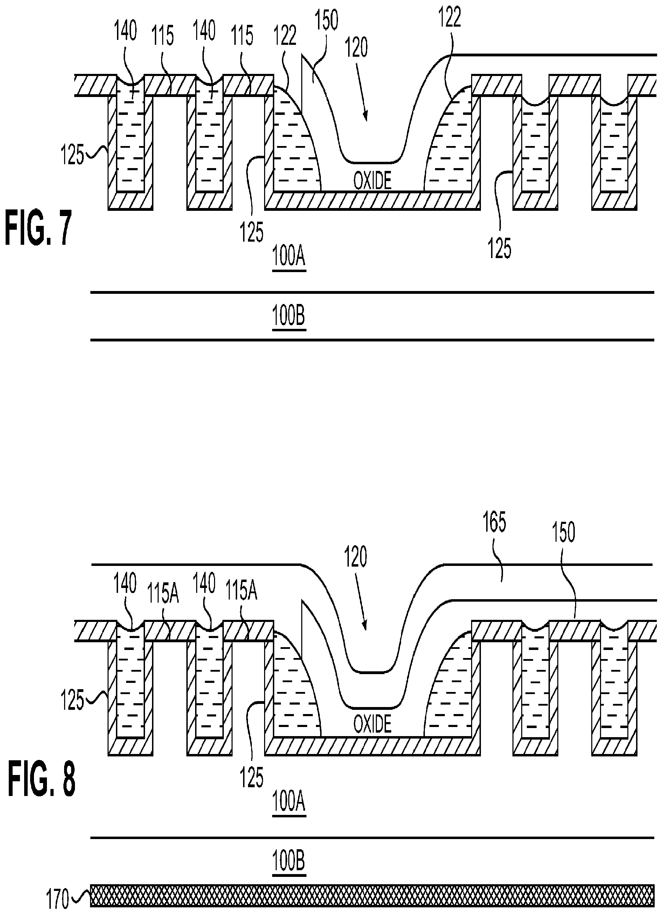

Referring now to FIG. 7 an anisotropic etching is performed to remove the excess first conductive layer 140. After this etching process, at least one spacer-like MOS gate 122 is formed from a conductive material on the oxide layer 125 lining the sidewall of the termination trench 120. As shown, a MOS gate 122 may also be formed on the opposing sidewall of the termination trench 120. In some examples the spacer-like MOS gate 122 has a width (along the cross-sectional view that is shown) that is about equal to the height of the termination trench 120.

A dielectric layer 150 is next formed in the termination region using an etching process. The dielectric layer 150 may be, for example, a TEOS layer such as an LPTEOS or PETEOS layer or an O₃ -TEOS or HTO layer. In some examples the thickness of the dielectric layer 150 may be between about 0.2-1.0 micron. The dielectric layer 150 partially covers the MOS gate 122 and the remainder of the termination trench 120 as well as the oxide layer 125 covering the guard ring trenches 1 11 and the portions of the first layer 110A between the termination trench 120 and the guard ring trenches 111.

Next, in FIG. 8 a sputtering or other suitable process is performed to deposit a conductive layer 165 over the entire structure so as to form Schottky contact regions 115A on mesas 115. The conductive layer 165 may be formed from any material that can form a Schottky diode with the underlying first layer 100A. For example, second conductive layer 160 may be a metal silicide layer. Finally, a cathode electrode 170 is deposited on the backside of substrate 100B.

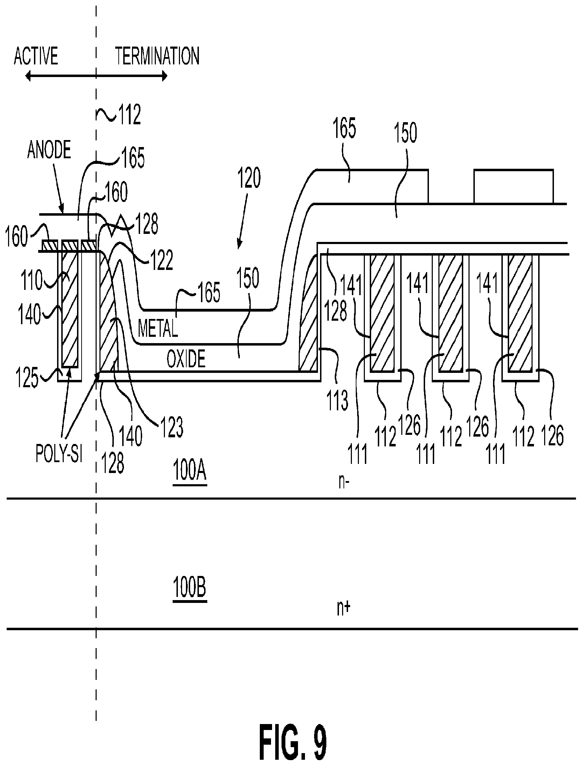

FIG. 9 illustrates an alternative embodiment of the invention. The main structure is similar to the embodiment described in FIG. 2 except the anode metal is partially etched over the guard ring region, forming segmented field plates as floating electrodes.

### Example

By way of illustration, various structural dimensions and parameters will be specified for one particular embodiment of the invention that includes four guard rings. In this embodiment the termination trench 120 has a width ranging from 10 - 50 microns and a depth that may be the same or different from the depth of the trenches 110 in the active region. Depending on the particular design and desired device characteristics (e.g., voltage capability, speed, leakage current) the depth of the termination trench 120 may range from 0.5-10 microns. The dielectric layer 150 located in the termination trench 120 may be silicon dioxide layer having a thickness between about 150 - 1,500 nm (1500 - 15,000 angstroms), depending on the blocking voltage that is required and the composition of the material.

The guard ring trenches have a width between 0.2 and 2.0 microns and a depth between 0.5 and 10 microns. The width and depth of the guard ring trenches may be the same or different from one another. The field plate defined by the extension of conductive layers 160 and 165 into the termination region may have a length between about 5 and 50 microns in the termination trench 120.

It should be noted that the termination structure described above may be used in connection with devices other than TMBS Schottky diodes, which has been presented by way of illustration only. For example, the termination structure can be applied to any power transistor such as a doubled diffused metal-oxide-semiconductor field effect transistor (DMOSFET), an insulated gate bipolar transistor (IGBT) and other trench MOS devices.

## Claims

1. A semiconductor device comprising a termination structure, said semiconductor device comprising:
- a semiconductor substrate (100) having an active region and a termination region;
- a termination trench (120) located in the termination region and extending from a boundary (112) of the active region toward an edge of the semiconductor substrate (100);
- a MOS gate (122) formed on a sidewall of the termination trench (120) adjacent said boundary (112);
- a termination structure oxide layer (150) formed in the termination trench (120) and partially covering the MOS gate (122);
- a first conductive layer (170) formed on a backside surface of the semiconductor substrate (100); and
- a second conductive layer (165) formed atop the active region and the termination region, said second conductive layer (165) extending into the termination trench so as to cover the MOS gate (122) and to make contact with exposed surfaces of the conductive material (123) of the MOS gate (122);
**characterized in that**
- at least one guard ring trench (111) is formed in the termination region on a side of the termination trench (120) remote from the active region, the termination trench (120) being spaced apart from the closest of the at least one guard ring trench (111) only by a mesa of semiconductor material;
- said termination structure oxide layer (150) is formed on the at least one guard ring trench (111);
- the at least one guard ring trench (111) is lined with an insulating layer (126), a conductive material (141) being disposed on said insulating layer (126) and filling said at least one guard ring trench (111); and
- the second conductive layer (165) extends so as to cover the termination trench (120) and the at least one guard ring trench (111).

2. The semiconductor device of claim 1, wherein said MOS gate (122) comprises said conductive layer (123) and a gate oxide layer (128) formed between a bottom of the termination trench (120) and the second conductive layer (165) .

3. The semiconductor device of claim 1, wherein said semiconductor device is a Schottky diode, especially a TMBS Schottky diode that includes at least one trench (110) in the active region of the substrate (100), or is a power transistor.

4. The semiconductor device of claim 1, wherein the second conductive layer (165) extends as a continuous layer.

5. The semiconductor device of claim 1, wherein the at least one guard ring trench (111) includes a plurality of guard ring trenches (111) and the termination structure oxide layer (150) and the second conductive layer (165) serve as a field plate.

6. The semiconductor device of claim 1, wherein the semiconductor device is a Schottky diode, comprising:
- a plurality of trench MOS devices spaced from each other formed in the active region of the semiconductor substrate (100);
wherein
- the second conductive layer (165) defines one or more Schottky barriers with one or more portions of the substrate (100) located between adjacent ones of the trench MOS devices and serves as a field plate on the termination region.

7. The Schottky diode of claim 6, wherein said semiconductor substrate (100) comprises a first layer (100A) and a base substrate (100B), and said first layer (100A) has a first type of conductive impurities lightly doped and said base substrate (100B) has said first type of conductive impurities heavily doped.

8. The Schottky diode of claim 7, wherein said trench MOS devices and said termination trench (120) are formed in said first layer (100A) having a depth of between about 0.5-10.0 microns and/or wherein said termination trench (120) has a width between about 10-50 microns.

9. The Schottky diode of claim 6, wherein said trench MOS devices and said MOS gate (122) include a material selected from the group consisting of metal, polysilicon, and amorphous silicon.

10. The Schottky diode of claim 6, further comprising one or more segmented metal regions, especially at least two segmented metal regions spaced apart from one another by between about 0.3 and 10 microns, located on the oxide layer (150) over the guard ring trenches (111) and spaced apart from the field plate.

11. A method of forming a semiconductor device, comprising:
- forming at least one trench MOS device in an active region of a substrate (100) having a first type of conductivity;
- forming a termination trench (120) and at least one guard ring trench (111) in a termination region of the substrate (100), the termination trench (120) extending from a boundary (112) of the active region toward an edge of the semiconductor substrate (100), the at least one guard ring trench (111) being formed in the termination region on a side of the termination trench (120) remote from the active region, the termination trench (120) being spaced apart from the closest of the at least one guard ring trench (111) only by a mesa of semiconductor material;
- forming a MOS gate (122) adjacent to a sidewall of the termination trench (120);
- lining the at least one guard ring trench with an insulating layer (126);
- depositing a conductive material (141) filling the at least one guard ring trench (111);
- forming a termination structure oxide layer (150) in the termination trench (120) so as to partially cover the MOS gate (122) and on the at least one guard ring trench (111);
- forming a first conductive layer (170) on a backside surface of the semiconductor substrate (100); and
- forming a second conductive layer (165) atop the active region and the termination region, said second conductive layer (165) extending into the termination trench so as to cover the MOS gate (122) and to make contact with exposed surfaces of the conductive material (123) of the MOS gate (122), said second conductive layer (165) extending so as to cover the termination trench (120) and the at least one guard ring trench (111).

12. The method of claim 11, further comprising:
- forming an insulating layer (125) in the trench (110) of the at least one trench MOS device; and
- depositing a conductive material (140) in the trench (110) of the at least one trench MOS device.

13. The method of claim 12, wherein the insulating layer (125) in the trench (110) of the at least one trench MOS device and the insulating layer (126) in the at least one guard ring trench (111) are formed simultaneously with one another and the conductive material (140) deposited in the trench (110) of the at least one trench MOS device and the conductive material (141) filling the at least one guard ring trench (111) are deposited simultaneously with one another.

## Patentansprüche

1. Halbleitervorrichtung mit einer Abschlussstruktur, wobei diese Halbleitervorrichtung umfasst:
- ein Halbleitersubstrat (100) mit einem aktiven Bereich und einem Abschlussbereich;
- einen Abschlussgraben (120), welcher sich in dem Abschlussbereich befindet und sich von einer Grenze (112) des aktiven Bereichs zu einem Rand des Halbleitersubstrats (100) erstreckt;
- ein MOS-Gate (122), welches an einer Seitenwand des Abschlussgrabens (120) neben dieser Grenze (112) ausgebildet ist;
- eine Oxidschicht (150) der Abschlussstruktur, welche in dem Abschlussgraben (120) ausgebildet ist und das MOS-Gate (122) teilweise bedeckt;
- eine erste leitende Schicht (170), welche auf einer Rückseitenfläche des Halbleitersubstrats (100) ausgebildet ist; und
- eine zweite leitende Schicht (165), welche über dem aktiven Bereich und dem Abschlussbereich ausgebildet ist, wobei sich diese zweite leitende Schicht (165) in den Abschlussgraben erstreckt, um das MOS-Gate (122) zu bedecken und Kontakt mit freiliegenden Oberflächen des leitenden Materials (123) des MOS-Gates (122) herzustellen;
**dadurch gekennzeichnet, dass**
- mindestens ein Schutzringgraben (111) in dem Abschlussbereich auf einer Seite des Abschlussgrabens (120), welche von dem aktiven Bereich entfernt ist, ausgebildet ist, wobei der Abschlussgraben (120) von dem nächstgelegenen des mindestens einen Schutzringgrabens (111) nur durch eine Mesa aus Halbleitermaterial beabstandet ist;
- diese Oxidschicht (150) der Abschlussstruktur auf dem mindestens einem Schutzringgraben (111) ausgebildet ist;
- der mindestens eine Schutzringgraben (111) mit einer Isolierschicht (126) ausgekleidet ist, wobei ein leitendes Material (141) auf dieser Isolierschicht (126) angeordnet ist und diesen mindestens einen Schutzringgraben (111) ausfüllt; und
- die zweite leitende Schicht (165) sich so erstreckt, dass sie den Abschlussgraben (120) und den mindestens einen Schutzringgraben (111) bedeckt.

2. Halbleitervorrichtung nach Anspruch 1, wobei dieses MOS-Gate (122) diese leitende Schicht (123) und eine zwischen einem Boden des Abschlussgrabens (120) und der zweiten leitenden Schicht (165) gebildete Gate- Oxidschicht (128) umfasst.

3. Halbleitervorrichtung nach Anspruch 1, wobei diese Halbleitervorrichtung eine Schottky-Diode ist, insbesondere eine TMBS-Schottky-Diode, die mindestens einen Graben (110) im aktiven Bereich des Substrats (100) aufweist, oder ein Leistungstransistor ist.

4. Halbleitervorrichtung nach Anspruch 1, wobei die zweite leitende Schicht (165) sich als eine durchgehende Schicht erstreckt.

5. Halbleitervorrichtung nach Anspruch 1, wobei der mindestens eine Schutzringgraben (111) eine Vielzahl an Schutzringgräben (111) einschließt und die Oxidschicht (150) der Abschlussstruktur und die zweite leitende Schicht als eine Feldplatte dienen.

6. Halbleitervorrichtung nach Anspruch 1, wobei die Halbleitervorrichtung eine Schottky-Diode ist, umfassend:
- eine Vielzahl an voneinander beabstandeten Graben-MOS-Bauelementen, die im aktiven Bereich des Halbleitersubstrats (100) ausgebildet sind;
wobei
- die zweite leitende Schicht (165) eine oder mehrere Schottky-Barrieren definiert, wobei sich ein oder mehrere Abschnitte des Substrats (100) zwischen benachbarten Graben-MOS-Bauelementen befinden und als Feldplatte auf dem Abschlussbereich dienen.

7. Schottky-Diode nach Anspruch 6, wobei das Halbleitersubstrat (100) eine erste Schicht (100A) und ein Basissubstrat (100B) umfasst, und diese erste Schicht (100A) einen ersten Typ leitender Verunreinigungen leicht dotiert aufweist und dieses Basissubstrat (100B) diesen ersten Typ leitender Verunreinigungen stark dotiert aufweist.

8. Schottky-Diode nach Anspruch 7, wobei diese Graben-MOS-Bauelemente und dieser Abschlussgraben (120) in der ersten Schicht (100A) mit einer Tiefe zwischen etwa 0,5-10,0 Mikrometern ausgebildet sind und/oder wobei dieser Abschlussgraben (120) eine Breite zwischen etwa 10-50 Mikrometern hat.

9. Schottky-Diode nach Anspruch 6, wobei diese Graben-MOS-Bauelemente und dieses MOS-Gate (122) ein Material enthalten, das aus einer Gruppe ausgewählt ist, die aus Metall, Polysilizium und amorphem Silizium besteht.

10. Schottky-Diode nach Anspruch 6, weiterhin umfassend einen oder mehrere segmentierte Metallbereiche, insbesondere mindestens zwei segmentierte Metallbereiche, die zwischen etwa 0,3 und 10 Mikrometer voneinander beabstandet sind und sich auf der Oxidschicht (150) über den Schutzringgräben (111) befinden und von der Feldplatte beabstandet sind, umfasst.

11. Verfahren zur Herstellung einer Halbleitervorrichtung, umfassend:
- Ausbilden mindestens eines Graben-MOS-Bauelements in einem aktiven Bereich eines Substrats (100) mit einem ersten Typ einer Leitfähigkeit;
- Ausbilden eines Abschlussgrabens (120) und mindestens eines Schutzringgrabens (111) in einem Abschlussbereich des Halbleitersubstrats (100), wobei sich der Abschlussgraben (120) von einer Grenze (122) des aktiven Bereichs zu einem Rand des Halbleitersubstrats (100) erstreckt, wobei der der mindestens eine Schutzringgraben (111) in dem Abschlussbereich auf einer von dem aktiven Bereich entfernten Seite des Abschlussgrabens (120) ausgebildet ist, wobei der Abschlussgraben (120)von dem nächstgelegenen des mindestens einen Schutzringgrabens (111) nur durch eine Mesa aus Halbleitermaterial beabstandet ist;
- Ausbilden eines MOS-Gates (122), welches an einer Seitenwand des Abschlussgrabens (120) anliegt;
- Auskleiden des mindestens einen Schutzringgrabens mit einer Isolierschicht (126);
- Aufbringen eines leitenden Materials (141), welches den mindestens einen Schutzringgraben (111) ausfüllt;
- Ausbilden einer Oxidschicht (150) der Abschlussstruktur in dem Abschlussgraben (120), um das MOS-Gate (122) und den mindestens einen Schutzringgraben (111) teilweise zu bedecken;
- Ausbilden einer ersten leitenden Schicht (170) auf einer Rückseitenfläche des Halbleitersubstrats (100); und
- Ausbilden einer zweiten leitenden Schicht (165) über dem aktiven Bereich und dem Abschlussbereich, wobei sich diese leitende Schicht (165) in den Abschlussgraben erstreckt, um das MOS-Gate (122) zu bedecken und Kontakt mit freiliegenden Oberflächen des leitenden Materials (123) des MOS-Gates (122) herzustellen, wobei sich diese zweite leitende Schicht(165) erstreckt, um den Abschlussgraben (120) und den mindestens einen Schutzringgraben (111) zu bedecken.

12. Verfahren nach Anspruch 11, ferner umfassend:
- Ausbilden einer Isolierschicht (125) im Graben (110) des mindestens einen Graben-MOS-Bauelements; und
- Abscheidung eines leitenden Materials (140) in dem Graben (100) des mindestens einen Graben-MOS-Bauelements.

13. Verfahren nach Anspruch 12, wobei die Isolierschicht (125) in dem Graben (110) des mindestens einen Graben-MOS-Bauelements und die Isolierschicht (126) in dem mindestens einen Schutzringgraben (111) gleichzeitig miteinander gebildet werden, und das in dem Graben (110) des mindestens einen Graben-MOS-Bauelements abgeschiedene leitende Material (140) und das den mindestens einen Schutzringgraben (111) füllende leitende Material (141) gleichzeitig miteinander abgeschieden werden.

## Revendications

1. Dispositif semi-conducteur comprenant une structure de clôture, ledit dispositif semi-conducteur comprenant:
- un substrat semi-conducteur (100) comportant une zone active et une zone de clôture;
- une saignée de clôture (120) située dans la zone de clôture et s'étendant depuis une limite (112) de la zone active vers un bord du substrat semi-conducteur (100);
- une grille MOS (122) formée sur une paroi latérale de la saignée de clôture (120) et adjacente à ladite limite (112);
- une couche oxydée de structure de clôture (150) formée dans la saignée de clôture (120) et couvrant partiellement la grille MOS (122);
- une première couche conductrice (170) formée sur une surface arrière du substrat semi-conducteur (100); et
- une seconde couche conductrice (165) formée en haut de la zone active et de la zone de clôture, ladite seconde couche conductrice (165) s'étendant dans la saignée de clôture de manière à couvrir la grille MOS (122) et à établir un contact avec les surfaces exposées du matériau conducteur (123) de la grille MOS (122);
**caractérisé en ce que**
- au moins une saignée annulaire de garde (111) est formée dans la zone de clôture sur une face de la saignée de clôture (120) distante de la zone active, la saignée de clôture (120) étant espacée du plus proche de l'au moins une saignée annulaire de garde (111) seulement par une plaque de matériau semi-conducteur;
- ladite couche oxydée de structure de clôture (150) est formée sur l'au moins une saignée annulaire de garde (111);
- l'au moins une saignée annulaire de garde (111) est doublée d'une couche isolante (126), un matériau conducteur (141) étant disposé sur ladite couche isolante (126) et remplissant ledit au moins une saignée annulaire de garde (111); et
- la seconde couche conductrice (165) s'étendant de manière à couvrir la saignée de clôture (120) et l'au moins une saignée annulaire de garde (111).

2. Dispositif semi-conducteur selon la revendication 1, dans lequel ladite grille MOS (122) comprend ladite couche conductrice (123) et une couche oxydée de grille (128) formée entre un fond de la saignée de clôture (120) et la seconde couche conductrice (165).

3. Dispositif semi-conducteur selon la revendication 1, dans lequel ledit dispositif semi-conducteur est une diode Schottky, spécialement une diode Schottky TMBS, qui inclut au moins une saignée (110) dans la zone active du substrat (100), ou est un transistor de puissance.

4. Dispositif semi-conducteur selon la revendication 1, dans lequel la seconde couche conductrice (165) s'étend sous forme d'une couche continue.

5. Dispositif semi-conducteur selon la revendication 1, dans lequel l'au moins une saignée annulaire de garde (111) inclut une pluralité de saignées annulaires de garde (111) et la couche oxydée de structure de clôture (150) et la seconde couche conductrice (165) servent de plaque de champ.

6. Dispositif semi-conducteur selon la revendication 1, dans lequel le dispositif semi-conducteur est une diode Schottky, comprenant:
- une pluralité de dispositifs MOS de saignée espacés les uns des autres et formés dans la zone active du substrat semi-conducteur (100);
- la seconde couche conductrice (165) définit une ou plusieurs barrières Schottky avec une ou plusieurs sections du substrat (100) situées entre les dispositifs adjacents parmi les dispositifs MOS de saignée et sert de plaques de champ sur la zone de clôture.

7. Diode Schottky selon la revendication 6, dans laquelle ledit substrat semi-conducteur (100) comprend une première couche (100A) et un substrat de base (100B), et ladite première couche (100A) comporte un premier type d'impuretés conductrices légèrement dopées et ledit substrat de base (100B) comporte ledit premier type d'impuretés conductrices lourdement dopées.

8. Diode Schottky selon la revendication 7, dans laquelle lesdits dispositifs MOS et ladite saignée de clôture (120) sont formés dans ladite première couche (100A) ayant une épaisseur comprise entre environ 0,5 à 10,0 microns et/ou ladite saignée de clôture (120) a une largeur comprise entre environ 10 et 50 microns.

9. Diode Schottky selon la revendication 6, dans laquelle lesdits dispositifs MOS et ladite grille MOS (122) inclut un matériau sélectionné dans le groupe composé de métal, de polysilicone et de silicone amorphe.

10. Diode Schottky selon la revendication 6, comprenant en outre une ou plusieurs zones métalliques segmentées, spécialement au moins deux zones métalliques segmentés espacées les unes des autres d'environ 0,3 à 10 microns, situées sur la couche oxydée (150) au-dessus des saignées annulaires de garde (111) et espacées de la plaque de champ.

11. Procédé de formage d'un dispositif semi-conducteur, comprenant:
- le formage d'au moins un dispositif MOS de saignée dans une zone active d'un substrat (100) ayant un premier type de conductivité;
- le formage d'une saignée de clôture (120) et d'au moins une saignée annulaire de garde (111) dans une zone de clôture du substrat (100), la saignée de clôture (120) s'étendant depuis une limite (112) de la zone active vers un bord du substrat semi-conducteur (100), l'au moins une saignée annulaire de garde (111) étant formée dans la zone de clôture sur une face de la saignée de clôture (120) distante de la zone active, la saignée de clôture (120) étant espacée de la plus proche de l'au moins une saignée annulaire de garde (111) seulement par une plaque de matériau semi-conducteur;
- le formage d'une grille MOS (122) adjacente à une paroi latérale de la saignée de clôture (120);
- le doublage de l'au moins une saignée annulaire de garde avec une couche isolante (126);
- le dépôt d'un matériau conducteur (141) remplissant l'au moins une saignée annulaire de garde (111);
- le formage d'une couche oxydée de structure de clôture (150) dans la saignée de clôture (120) de manière à couvrir partiellement la grille MOS (122) et sur l'au moins une saignée annulaire de garde (111);
- le formage d'une première couche conductrice (170) sur une surface arrière du substrat semi-conducteur (100); et
- le formage d'une seconde couche conductrice (165) au-dessus de la zone active et de la zone de clôture, ladite seconde couche conductrice (165) s'étendant dans la saignée de clôture de manière à couvrir la grille MOS (122) et à établir un contact avec les surfaces exposées du matériau conducteur (123) de la grille MOS (122), ladite seconde couche conductrice (165) s'étendant de manière à couvrir la saignée de clôture (120) et l'au moins une saignée annulaire de garde (111).

12. Procédé selon la revendication 11, comprenant en outre:
- le formage d'une couche isolante (125) dans la saignée (120) de l'au moins un dispositif MOS de saignée; et
- le dépôt d'une couche conductrice (140) dans la saignée (110) de l'au moins un dispositif MOS de saignée.

13. Procédé selon la revendication 12, dans lequel la couche isolante (125) dans la saignée (110) de l'au moins un dispositif MOS de saignée et la couche isolante (126) dans l'au moins une saignée annulaire de garde (111) sont formées simultanément l'une avec l'autre et le matériau conducteur (140) disposé dans la saignée (110) de l'au moins un dispositif MOS de saignée et le matériau conducteur (141) remplissant l'au moins une saignée annulaire de garde (111) sont déposés simultanément l'un avec l'autre.
